# NOUVEAU FASCICULE DE BREVET EUROPEEN

(11) **EP 0 635 939 B2**
(45) Date de publication et mention de la décision concernant l'opposition: **02.02.2005**
(45) Mention de la délivrance du brevet: 30.09.1998
(21) Numéro de dépôt: 94401659.1
(22) Date de dépôt: 19.07.1994
(51) Int. Cl.: H03J 1/00, H04M 11/00

(54) **Procédé de téléchargement pour la programmation d'un récepteur radioélectrique à synthèse de fréquence**
Verfahren zur Fernabspeicherung von Abstimmdaten in einem Rundfunkempfänger mit Wellensynthese
Method for downloading of tuning data in a broadcast receiver using a frequency synthesiser

(30) Priorité: 23.07.1993 FR 9309108
(43) Date de publication de la demande: 25.01.1995
(73) Titulaire: THOMSON multimedia, 92648 Boulogne Cédex (FR)
(72) Inventeur: Staron, Alain, F-92402 Courbevoie Cedex (FR); Bourdarie, Jean-Philippe, F-92402 Courbevoie Cedex (FR)
(74) Mandataire: Ruellan-Lemonnier, Brigitte

(56) Documents cités:
- DE-A- 3 039 981
- DE-C2- 3 815 071
- GB-A- 2 201 065
- GB-A- 2 258 583
- US-A- 5 228 077
- "Neue Tele-Medien von A-Z", P. Lanzendorf, vol. GFU4, VDE-Verlag GmbH, 1983 Berlin, pages 28-39
- "Bildschirmtext-Handbuch", Loseblatt-Sammlung, Handbuch-Teil 4.3, page"CDI" publié par Verlag Moderne Industrie, Landsberg, Février 1984
- Bildschirmtext, E.P. Rupp, Oldenbourg Verlag GmbH, München 1980, p. 12-15

## Description

La présente invention se rapporte aux récepteurs radio à changement de fréquence utilisant un synthétiseur de fréquence comme oscillateur local. Des moyens à mémoire contiennent des données qui permettent de sélectionner, en le désignant simplement par son rang, le programme radiodiffusé que l'on désire capter dans une région déterminée. Les programmes de télévision sont diffusés par ondes hertziennes de courte longueur d'onde selon un plan d'allocation de fréquence se décomposant en canaux numérotés auxquels correspondent des fréquences porteuses prédéterminées. D'une région géographique à l'autre, pour éviter les interférences, on est amené à diffuser un même programme sur des canaux différents. Il n'est donc pas possible de programmer un récepteur à synthèse de fréquence tel qu'un récepteur de télévision ou un magnétoscope d'une manière unique et définitive au départ du lieu de fabrication. Il convient donc de réaliser la programmation à la mise en service en tenant compte des particularités régionales. Comme l'utilisateur profane éprouve des difficuftés à programmer son récepteur, on peut imaginer de mettre à sa disposition un circuit intégré à mémoire qui a été programmé en vue d'une utilisation dans une région particulière. Cette solution repose sur un assortiment de circuits à gérer, ce qui complique la distribution des produits. L'insertion d'un tel circuit par l'utilisateur peut être une source de panne et son changement lors d'un déménagement dans une autre région représente une intervention délicate. La préprogrammation sur le lieu d'utilisation peut se faire en utilisant des aides diverses, par exemple un lecteur de codes barres ou encore, un clavier numérique associé à un guide de programmation. Cette façon de procéder nécessite encore des manipulations de la part de l'utilisateur et la consultation d'un document précisant les diverses possibilités de programmation.

De nos jours, tout le monde est familiarisé avec l'usage du téléphone public et il existe des services téléphoniques auxquels on peut, de n'importe où, s'adresser gratuitement pour obtenir des renseignements de toutes sortes. C'est sur cette constatation que repose l'invention d'un nouveau mode de téléchargement particulièrement aisé à mettre en oeuvre.

On connaît par le brevet US 5,228,077, un procédé de programmation d'un récepteur radioélectrique à synthèse de fréquence destiné à être commandé au moyen d'une télécommande et comprenant une mémoire réinscriptible qui renferme des données numériques destinées au réglage en fréquence des moyens de syntonisation dudit récepteur, l'appel desdites données étant géré par le choix d'un programme diffusé figurant dans une liste ordonnée connue de l'opérateur.

L'invention a pour objet un procédé de téléchargement fondé sur l'utilisation du réseau téléphonique public et sur l'appel par l'utilisateur d'un récepteur d'un numéro payant ou gratuit, afin que lui soient servies via la ligne téléphonique, des données de programmation appropriées à sa région.

Plus précisément, il s'agit d'un procédé de programmation d'un récepteur radioélectrique à synthèse de fréquence comprenant une mémoire reinscriptible qui renferme des données numériques destinées au réglage en fréquence des moyens de syntonisation dudit recepteur, l'appel desdites données étant géré par le choix d'un programme diffusé figurant dans une liste ordonnée connue de l'opérateur, caractérisé en ce que lesdites données sont téléchargées dans ladite mémoire en lançant via le réseau téléphonique public un appel destiné à un centre de chargement qui détient, pour plusieurs régions de réception, des jeux de données appropriées à la programmation de ladite mémoire réinscriptible, le jeu de données téléchargées étant fonction de l'indication de la région d'origine de l'appel téléphonique fournie par l'opérateur du réseau téléphonique, un jeu de données comportant, pour sa région, le plan d'allocation de fréquences correspondant, sous la forme des données numériques destinées au réglage en fréquence des moyens de syntonisation.

L'invention sera mieux comprise au moyen de la description ci-après et des figures annnexées parmi lesquelles:
La figure 1 illustre un système de téléchargement conforme à l'invention.
La figure 2 est un schéma de réalisation du système de la figure 1.

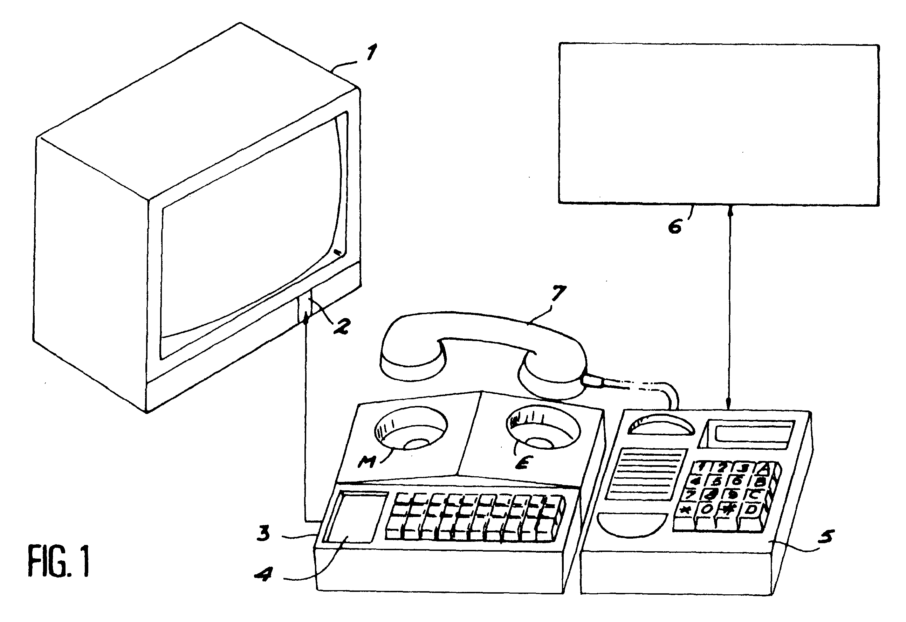

Sur la figure 1, on peut voir un récepteur radioélectrique 1, tel qu'un récepteur de télévision ou un magnétoscope qui est télécommandé par un rayonnement infrarouge modulé reçu par la fenêtre 2. Ce rayonnement infrarouge est émis par un boitier de télécommande 3 qui comprend en général un clavier à touches et un dispositif d'affichage 4. Ce boitier de télécommande 3 pourrait aussi bien comporter des manettes de commande agissant sur des index apparaissant sur l'écran d'un téléviseur avec des menus appropriés.

Dans le cas de la figure 1, le boitier de télécommande comporte deux logements M et E destinés respectivement à recevoir l'écouteur et le microphone d'un combiné téléphonique 7. Le logement M est couplé à un microphone interne et le logement E est couplé à un écouteur interne. Ces deux transducteurs acoustoélectriques sont reliés à un circuit modulateur-démodulateur (MODEM) qui réalise l'interface avec un circuit à microprocesseur utilisé pour émettre des commandes par modulation d'un rayonnement infrarouge. On peut également envisager un système simplifié et moins coûteux dans lequel, seules les données provenant de l'écouteur du combiné 7 sont utilisées pour programmer le récepteur, sans faire usage de la possibilité d'une liaison téléphonique en sens inverse. Dans le cas de la figure 1, le poste téléphonique 5 est relié d'une part au réseau téléphonique public 6 et d'autre part au boitier de télécommande 3 par une liaison acoustique via le combiné 7. Il existe à l'intérieur du réseau 6 un centre de téléchargement qui lors d'un appel de l'utilisateur du récepteur 1, va transmettre à destination de ce récepteur des données qui assurent la programmation à distance de la mémoire du système de syntonisation. L'avantage de la liaison par modem acoustique au niveau de la télécommande infrarouge est d'éviter tout raccordement par fil, cependant, l'invention couvre aussi le cas d'un raccordement téléphonique par fil avec la télécommande 3 ou directement avec le récepteur 1 qui contient le système de syntonisation. La liaison acoustique est d'une mise en oeuvre aisée pour l'utilisateur et elle ne doit être établie qu'une fois, lors de la mise en service du récepteur de télévision dans chaque nouvelle région. Un coupleur magnétique à ventouse peut également assurer la connexion grâce au rayonnement magnétique émis par le poste téléphonique.

Il y a lieu de remarquer que la programmation du système de syntonisation d'un téléviseur à synthèse de fréquence n'est pas la même pour une réception hertzienne et pour une réception par câble. Pour différencier ces deux possibilités, on peut inviter l'utilisateur à choisir entre deux numéros distincts d'appel gratuit, ou, si le centre de téléchargemenf n'a qu'un seul numéro d'appel, à demander à l'utilisateur d'émettre une commande appropriée. La reconnaissance de la région d'où provient l'appel peut être déterminée au centre de téléprogrammation en accord avec l'opérateur du réseau téléphonique.

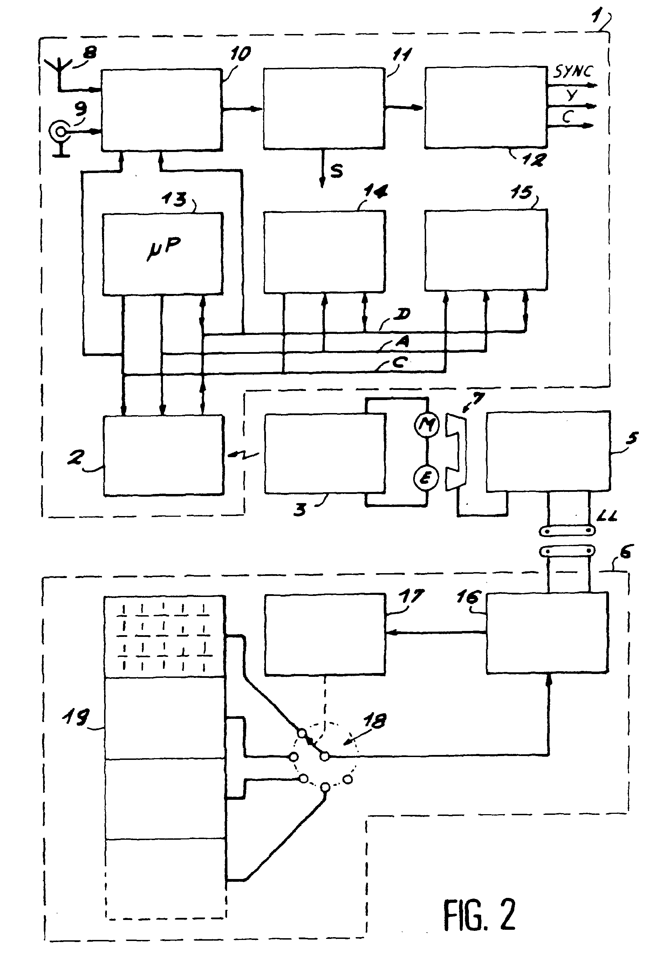

La figure 2 représente, à titre d'exemple non-limitatif, le schéma d'un récepteur de télévision 1 qui comprend un tuner 10 à synthèse de fréquence susceptible d'être raccordé à une antenne 8 ou à un réseau cablé 9. Le tuner comporte un registre d'accord dans lequel on charge un nombre binaire qui détermine la fréquence à recevoir. Ce registre est relié à un bus de données D et à un bus de contrôle C. Ces deux bus sont eux-mêmes reliés à un microprocesseur 13, à une mémoire électriquement reprogrammable 14 et à des mémoires RAM/ROM 15. Un bus d'adresse A est également prévu ainsi qu'un récepteur de télécommande infrarouge 2. Le tuner 10 délivre après amplification à fréquence intermédiaire sur des voies son et image un signal sonore S et un signal video composite. Les amplificateurs des voies son et image sont contenus dans une platine 11 reliée au tuner 10 et à un circuit 12 qui sépare les signaux de synchronisation SYNC, le signal de luminance Y et les signaux de chrominance C. L'exploitation des signaux n'a pas été détaillée sur la figure 2. Le récepteur de télécommande 2 reçoit un rayonnement infrarouge modulé qui est émis par le boitier de télécommande 3 placé à proximité du poste téléphonique 5. Le combiné téléphonique 7 est relié acoustiquement à un microphone M qui retransmet les données audibles transportées par la ligne LL du réseau téléphonique 6. Il est également relié à un écouteur E lorsqu'on prévoit d'émettre avec le boitier 3 une commande à destination du centre de téléchargement. Le centre de téléchargement comporte un central 16 relié à la ligne LL, une mémoire 17 reliée à ce central et un circuit de sélection 18 qui permet de choisir en fonction du contenu de la mémoire 17 un des jeux de données emmagasinés dans la mémoire 19.

Un jeu de données comprend autant de groupements de données qu'il y a de programmes à recevoir rangés sous une étiquette qui caractérise la région de réception. Chaque ligne de programme comporte un numéro d'ordre, suivi par un mot binaire qui fixe la fréquence de fonctionnement du tuner. A ces deux informations, on peut ajouter le numéro de canal et le cas échéant le nom de la station qui, dans la région choisie, émet sur ce canal. On peut encore ajouter le code "GEMSTAR" permettant de simplifier la programmation des magnétoscopes. L'ensemble des lignes de programme attachées à une région représente une page de la mémoire 19. Cette page est sélectionnée en fonction du contenu de la mémoire 17. En effet, lorsque l'utilisateur désire programmer son récepteur de télévision, il compose un numéro gratuit sur son poste téléphonique 5, après avoir relié le combiné 7 au boitier de télécommande 3 et allumé le récepteur de télévision. Un affichage sur l'écran du téléviseur peut guider l'utilisateur sur ce qu'il doit faire (indication du numéro d'appel téléphonique à composer, etc.). Lorsque la ligne est établie, le central 7 peut localiser l'origine de l'appel téléphonique et charger dans la mémoire 17 un mot correspondant à l'une des étiquettes de régions. Le sélecteur 18 pointe alors le jeu d'instructions de programmation contenu dans la page de mémoire 19 sélectionnée par le contenu de la mémoire 17. Ce jeu d'instructions est alors envoyé vers l'écouteur du combiné 7 et grâce au microphone M les signaux sont admis dans le boitier 3 qui renferme un modulateur-démodulateur ( MODEM). Les signaux sont mis en forme pour être envoyés au récepteur de télécommande 2. Le microprocesseur 13 réalise le chargement des données parvenues au récepteur 2 dans la mémoire électriquement reprogrammable 14, où elles deviennent disponibles pour commander l'accord du tuner 10 dans la région où l'appel téléphonique a été lancé.

L'utilisateur est, par exemple, invité à l'énoncer à préciser s'il est ou non raccordé au câble.

Lorsque les données de téléchargement ont été chargées en mémoire, l'utilisateur est avisé par un message apparaissant soit sur la télécommande, soit sur l'écran du téléviseur.

Dans l'exemple décrit ci-dessus, c'est le boitier de télécommande du téléviseur qui est équipé en vue du couplage avec le réseau téléphonique. On peut, sans s'écarter de l'invention, prévoir un couplage direct avec le téléviseur ou le magnétoscope. Dans ce cas, on peut proposer un accessoire comportant une fiche téléphone et un connecteur pour se raccorder au bus interne du récepteur. Cet accessoire aura à respecter le protocole d'échange avec le réseau téléphonique et il comprendra aussi un contrôleur d'entrée-sortie pour gérer les échanges de données avec la mémoire électriquement reprogrammable qui contient la table de programmation du tuner.

Le mode d'emploi du système de programmation par téléchargement est particulièrement simple, puisqu'il comporte les phases suivantes:
- branchement du récepteur et couplage du combiné téléphonique avec un organe approprié dépendant du récepteur.
- le récepteur affiche un message précisant le numéro téléphonique à appeler suivant les moyens de réception utilisés ( antenne ou câble)
- l'appel sur le poste téléphonique public est lancé
- les information adéquates sont alors téléchargées
- le message "fin de chargement" apparait
- il ne reste plus qu'à raccrocher le téléphone.

L'avantage du procédé de programmation par téléchargement est de tenir compte des changements qui interviennent lorsque les stations reçues deviennent plus nombreuses.

II peut arriver qu'après le téléchargement, il soit nécessaire de retoucher le réglage du tuner par l'action sur des touches + et -. Une telle correction, manuelle ou automatique, se justifie en raison des conditions locales de réception.

Comme les récepteurs évoluent avec le temps, il peut être nécessaire de faire préciser par l'utilisateur la marque du produit et l'année de fabrication. Cependant, ce type d'information peut être acquis par le centre de téléchargement sans que l'utilisateur ait à intervenir, si les données peuvent être échangées de manière bilatérale.

La description qui précède n'a été donnée qu'à titre d'exemple non limitatif et il va de soi que d'autres variantes peuvent être envisagées, sans sortir du cadre de l'invention.

## Revendications

1. Procédé de programmation d'un récepteur radioélectrique à synthèse de fréquence comprenant une mémoire réinscriptible qui renferme des données numériques destinées au réglage en fréquence des moyens de syntonisation dudit récepteur, l'appel desdites données étant géré par le choix d'un programme diffusé figurant dans une liste ordonnée connue de l'opérateur, **caractérisé en ce que** lesdites données sont téléchargées dans ladite mémoire (14) en lançant via le réseau téléphonique public (6) un appel destiné à un centre de chargement qui détient, pour plusieurs régions de réception, des jeux de données appropriées à la programmation de ladite mémoire réinscriptible, le jeu de données téléchargé étant fonction de l'indication de la région d'origine de l'appel téléphonique fournie par l'opérateur du réseau téléphonique, un jeu de données comportant, pour sa région, le plan d'allocation de fréquences correspondant, sous la forme des données numériques destinées au réglage en fréquence des moyens de syntonisation.

2. Procédé selon la revendication 1, **caractérisé en ce qu'**il consiste à coupler un combiné téléphonique (7) d'un poste (5) utilisé pour l'appel à un boîtier de télécommande infrarouge (3) associé audit récepteur (1).

3. Procédé selon l'une quelconque des revendications 1 et 2, **caractérisé en ce qu'**il consiste à établir une liaison bilatérale entre ledit centre de chargement et les circuits de commande numérique dudit récepteur.

4. Procédé selon l'une quelconque des revendications précédentes, **caractérisé en ce que** le transfert des données met en oeuvre un coupleur acoustique et un modulateur-démodulateur.

## Claims

1. Programming process for a frequency synthesis radioelectric receiver containing a rewritable memory that holds digital data designed to adjust the frequency of the tuning means of the said receiver, the said data being called up by choosing a broadcast programme appearing in an ordered list known to the operator, **characterized in that** the said data are downloaded into the said memory (14) by using the public telephone network (6) to make a call to, a loading centre that retains sets of data appropriate to programming the said rewritable memory for several reception regions, the downloaded data set being dependent on the indication of the telephone call's region of origin provided by the operator of the telephone network, a data set comprising, for its region, the corresponding frequency allocation plan in the form of digital data intended for the frequency adjustment of the tuning means.

2. Process according to Claim 1, **characterized in that** it consists in coupling a telephone handset (7) of a phone (5) used for the call to an infra-red remote control box (3) associated with the said receiver (1).

3. Process according to either of Claims 1 and 2, **characterized in that** it consists in making a bilateral link between the said loading centre and the digital control circuits of the said receiver.

4. Process according to any one of the preceding claims, **characterized in that** the data transfer makes use of an acoustic coupler and a modulator-demodulator.

## Patentansprüche

1. Verfahren zur Programmierung eines Rundfunkempfängers mit Frequenzsynthese mit einem neu einschaltbaren Speicher, der digitale Daten enthält, die zur Frequenzeinstellung der Abstimmmittel des Empfängers dienen, wobei der Zugriff zu diesen Daten durch die Wahl eines Programms erfolgt, das in einer dem Bedienenden bekannten Übersichtsliste dargestellt ist,
**dadurch gekennzeichnet, dass**
die Daten in dem Speicher (14) fernabgespeichert werden, indem über das öffentliche Telefonnetz (6) ein Zugriff zu einem Speicherzentrum erfolgt, das für mehrere Empfangsgebiete Datensätze enthält, die für die Programmierung des neu einschreibbaren Speichers geeignet sind, und dass der fernabgespeicherte Datensatz abhängig von der Anzeige des Ausgangsgebiets des Telefongesprächs ist, das durch den Bedienenden des Telefonnetzes geführt wird, und ein Datensatz für seinen Bereich den Zuordnungsplan der entsprechenden Frequenzen in der Form von digitalen Daten enthält, die für die Frequenzregelung der Abstimmmittel bestimmt sind.

2. Verfahren nach Anspruch 1, **dadurch gekennzeichnet, dass** ein Telefonhörer (7) eines für den Zugriff verwendeten Telefonapparates (5) mit einer zu dem Empfänger (1) gehörenden Infrarot-Fernbedieneinheit (3) verbunden wird.

3. Verfahren nach einem der Ansprüche 1 und 2, **dadurch gekennzeichnet, dass** eine bilaterale Verbindung zwischen dem Speicherzentrum und den Schaltungen für die digitale Steuerung des Empfängers gebildet wird.

4. Verfahren nach einem der vorangehenden Ansprüche, **dadurch gekennzeichnet, dass** die Datenübertragung durch einen Akustikkoppler und einen Modulator-Demodulator durchgeführt wird.
